# EUROPEAN PATENT APPLICATION

(11) **EP 1 906 441 A1**
(43) Date of publication of application: **02.04.2008**
(21) Application number: 06020513.5
(22) Date of filing: 29.09.2006
(51) Int. Cl.: H01L 21/768, H01L 23/48

(54) **Wafer with semiconductor devices and method of manufacturing the same**

(71) Applicant: Schott Advanced Packaging Singapore Pte. Ldt., 738068 Singapore (DE)
(72) Inventor: Gautham, Viswanadam, Singapore 55 01 03 (SG); Sparschuh, Georg, Singapore 75 77 13 (SG); Muecke, Klaus W., Singapore 58 96 29 (SG); Leib, Juergen, Dr., 85354 Freisingen (DE)
(74) Representative: Blumbach - Zinngrebe

(57) **Abstract**

It is an object of the invention to improve wafer level packaging processes, in particular so as to enable for reduced bond pad or terminal pitches. For that purpose, a method for fabricating a wafer substrate for semiconductor circuits is provided, whereby
-etch pits are introduced into a wafer having a first side and an opposite second side, and
-conducting material is deposited into the etch pits, so that blind conducting channels are formed which extend from the first side of the wafer into the wafer substrate, and whereby the blind conducting channels are formed prior to fabricating or finishing semiconductor circuits on the first side of the wafer.

## Description

### FIELD OF THE INVENTION

The invention generally concerns the fabrication of semiconductor devices. In particular, the invention relates to forming electrical trough contacts in wafers for fabrication of semiconductor circuits.

### BACKGROUND OF THE INVENTION

Wafer level packaging (WLP) for semiconductor devices is discussed to be the future package of the semiconductor industry, as it offers many advantages to system miniaturization and integration. However, it remains an issue to realize the consumer markets requirements, particularly to provide satisfactory reliability and production costs. Today's major consumer markets in optical sensing and micro-electromechanical systems (MEMS) seem to demand WLP combined with low cost packaging. For example, MEMS packaging costs are higher than MEMS device costs. As well, optical image sensors require their sensing side to be clear from obstructions.

In the art of wafer level packaging, it is known to form conductors on the wafer which connect terminal contacts on the active side of the wafer with contact surfaces on its backside. By this means, wire bonds to the active side are avoided and a higher packaging density on the wafer can be achieved.

Current Wafer Level Packages which employ back-side contacting employ plated through holes, or contact lines extending around the sides of the chip substrats. The latter contact lines are known, e.g. from US-Patents 6,972,480, 6,777,767, 6,646,289 and 6,040,235.

These techniques are found to be limited particular with respect to the bond pad pitch. Devices having bond patches with below 150 micron pitch may be very difficult to be processed using known technologies due to the design guide lines that are associated with the through formation of the above mentioned contact types.

Furthermore, the presence of holes, via and die edges in the wafers involve non-planar surfaces, requiring very crucial process controls and monitoring to obtain acceptable packaging yields for mass production. The wafer level packaging process using these technologies also involves very expensive equipment and long process times.

### SUMMARY OF THE INVENTION

It is therefore an object of the invention to improve wafer level packaging processes, in particular so as to enable for reduced bond pad or terminal pitches.

According to the invention, a method for fabricating a wafer substrate for semiconductor circuits is provided, whereby
- etch pits are introduced into a wafer having a first side or face and an opposite second side or face,
- conducting material is deposited into the etch pits lined with the passivation layer, so that blind conducting channels are formed which extend from the first side of the wafer into the wafer substrate, and whereby the blind conducting channels are formed prior to fabricating or finishing semiconductor circuits on the first side of the wafer. The etch pits are preferably produced by photolithography.

Particularly for semiconducting wafer substrates, it is further advantageous to produce a passivation layer in the etch pits prior to deposition of conducting material. The passivation layer serves as electrical insulation between the conducting material and the substrate. If a silicon wafer is used as the wafer substrate, the passivation layer may be thermally grown silicon oxide.

It is particularly advantageous, if doped silicon is deposited as conducting material to fill the etch pits. Generally, this silicon will be polycrystalline. This allows for fabrication of silicon doped interconnections at the wafer fabrication facilities due to their existing equipment and capabilities. Up to now, formation of interconnects or conducting vias has been usually performed in the course of wafer level packaging. However, packaging and device fabrication are often carried out at different facilities. Accordingly, if the production of the buried or blind conducting channels is carried out by the device manufacturer, this advantageously reduces the final packaging costs significantly compared to known wafer level packaging technologies.

In a later fabrication step, the blind conducting channels are exposed on the second side of the wafer so as to form through contacts for contacting the semiconductor devices produced on the first side. Exposing the blind conducting channels is preferably perfomed by thinning the wafer from its second side. Specifically, the invention also provides a method of producing a wafer with semiconductor devices, wherein a wafer is produced as described above, and wherein semiconductor circuits are fabricated or finished on the first side of the wafer substrate, and wherein electrical connections are established from the semiconductor circuits to the blind conducting channels and wherein the wafer substrate is thinned from the second side at least until the blind conducting channels are uncovered at the second side so that contact regions are produced at the second side which establish an electrical connection via the conducting channels to the semiconductor circuits.

Accordingly, the inventive method addresses the above discussed issues by exposing interconnect contacts at the back of the wafer, as the excess material is removed from the back side. This facilitates processing the back side of the wafers by standard re-routing and bumping processes, eliminating expensive process steps that are usually associated with the existing technologies for formation of interconnect contacts.

If the process steps for forming the devices and exposing the blind conducting channels have been performed, a wafer is obtained hawing semiconductor devices comprising semiconductor circuits formed on a first side of the wafer substrate, whereby the semiconductor devices are connected to the conducting channels which extend through the wafer substrate and electrically connect the semiconductor devices to the second side, whereby the conducting channels comprise etch pits which are tapered towards the second side of the wafer substrate due to the etching, and whereby the etch pits are preferably lined with a passivation layer and filled with conducting material, preferably doped silicon.

The interconnects or through-contacts or conducting channels formed from the conductor material filled etch pits may be fabricated with lateral sizes of the order of 15 micron or less, even of about 7 micron or less and hence allow for very fine pitch interconnects on the back of the wafer. Particularly, etch pits or conducting channels, respectively may be produced having a pitch or lateral centre-centre distance of 150 micrometer or less, preferably 100 micrometer or less. It is further preferred to introduce high aspect-ratio etch pits. This enables for deep etch pits having low lateral dimensions. Using an appropriate etching method, etch pits may be produced having a ratio of depth to width of at least 3 to 1, preferably of at least 10 to 1.

The inventive technology provide flexibility for the device manufacturer to package the wafers with minimal packaging steps to complete the wafer packaging. Further, this invention method reduces the wafer level packaging cycle time and costs very significantly compared to the current wafer level packaging for optical or MEMS devices, and increases reliability and yield.

According to one embodiment of the invention, the blind conducting channels are introduced into a blank wafer. This way, a wafer substrate for fabricating semiconductor circuits thereon is obtained having first and second opposite sides, whereby blind conducting channels extend from the first side into the wafer substrate without extending down to said second side, and whereby the blind conducting channels comprise etch pits extending into the wafer substrate, with the etch pits being lined with a passivation layer and filled with conducting doped silicon.

According to another embodiment of the invention, the blind conducting channels are introduced into a wafer substrate which comprises prefabricated gate arrays on the first side. Again, a wafer substrate for fabricating semiconductor circuits thereon is obtained. In this case, however, finishing of the semiconductor circuits on the wafer substrate comprises forming metal interconnections between gates of the prefabricated gate arrays. This technique is generally employed in ASIC fabrication. As well, if a blank wafer is used, gate arrays, particularly for ASIC-fabrication may be produced thereon after the blind conducting channels have been introduced.

According to a further advantageous refinement, the first side of the wafer substrate is planarized after deposition of conducting material into the etch pits. The planar surface conforms to the surface of a blank wafer and thus facilitates fabrication of devices or functional layers such as interconnection layers.

The lateral device dimensions may be considerably reduced by the invention. In particular, the semiconductor circuits of the devices may advantageously produced over at least a part of the blind conducting channels so that the semiconductor circuits directly connect to the conducting channels. Accordingly, after the devices have been produced, the conducting channels are then positioned underneath the semiconductor circuits.

According to a further refinement of the invention, at least one electrical interconnection layer comprising electrical connection lines is produced on the first side of the wafer substrate connecting the semiconductor circuits to the conducting channels and/or establishing electrical connections between gates of gate arrays on the first side of the wafer substrate. In this case, the electrical connection layer may be produced over at least some of the blind conducting channels so that the conducting channels produced by thinning of the wafer substrate are positioned underneath the metal interconnection layer to achieve a compact design.

In order to stabilise the wafer during thinning, a support substrate may be bonded to the first side of the wafer so that the wafer is thinned from its second side with the support substrate bonded to the first side. The support substrate may advantageously also be a part of the packaging of the devices so that the bond may be permanently. For example, the support substrate and the wafer may be bonded using an adhesive such as epoxy. However, it is also possible to bond using a sol-gel to obtain a glass-like bond layer with particular low permeation. As well, the wafer may be bonded to the support substrate by anodic bonding.

The invention is particularly suited to fabricate or modify substrates for devices comprising metal-oxide semiconductor (MOS) elements such as CMOS elements and/or silicon-on-insulator (SOI) elements, as these devices may be formed by deposition of layers on the first side of the wafer substrate. A prefabrication of blind conducting channels as contemplated by the invention using doped silicon as conducting material is particular advantageous in connection with these types of semiconductor elements as high temperature treatments are generally employed for fabrication. Doped silicon, however, is highly temperature resistant. Further, if silicon wafers are used as substrates, doped silicon as conducting material facilitates the further processing of the wafer and/or the devices, as the conducting material in the etch pits is substantially the same as the surrounding substrate material.

The conducting channels produced according to the invention may also serve to connect to one or more interconnection layers produced on the second side of the wafer. Inter alia, this is advantageous for complex interconnections. For example, ASICs may be produced with a higher device density, whereby fabrication of the circuitry is finalised by forming interconnections betweenn the gates using interconnect layers on both sides of the substrate. For example, the first and the second side of the wafer may be used to deposit interconnection layers.

After semiconductor device fabrication on the wafer has been accomplished, separate chips may be diced from the wafer. Before dicing, a hermetic packaging on wafer level may be produced so that the diced chips are ready to use.

The invention may further advantageously used to fabricate chips with stacked semiconductor devices. This may be achieved by bonding the wafer to at least one further wafer produced similarly with conducting channels so that a wafer stack of semiconductor device wafers is obtained, whereby electrical connections between said devices on said wafer and said further wafer are produced. If wafers are stacked, the wafers are preferably thinned subsequently. A first wafer may be bonded to a support substrate and thinned on its second side to expose the blind conducting channels. Then, the next wafer may be bonded with its first side to the second side of the first wafer and then thinned to expose the blind conducting channels.

The above described features and advantages of the invention will become more apparent from a review of the following description, taken in conjunction with the accompanying drawings.

### BRIEF DESCRIPTION OF THE DRAWINGS

Fig. 1 to 4 illustrate fabrication steps for manufacture of a wafer substrate according to a first embodiment of the invention,
Figs. 5 to 7 show further process steps for device fabrication,
Fig. 8 shows a variant of the wafer depicted in Fig. 7,
Fig. 9 shows a wafer with prefabricated gate array.
Fig. 10 shows an embodiment with multilayer metal interconnection layers on both sides of the wafer.
Fig. 11 depicts an embodiment of a wafer stack,
Fig. 12 shows a chip diced from a wafer stack and mounted on a circuit board.

### DETAILED DESCRIPTION OF THE INVENTION

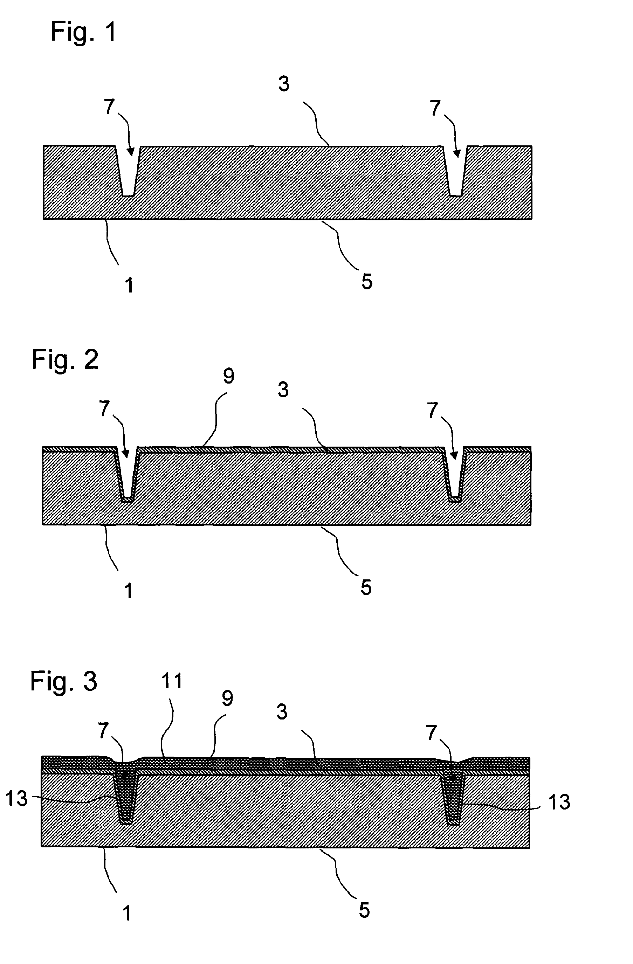

Figs. 1 to 7 show fabrication steps for producing a semiconductor wafer with semiconductor devices thereon according to a first embodiment of the invention. As shown in Fig. 1, a blank silicon semiconductor wafer 1, with opposite sides 3, 5 without any devices or semiconductor elements is used according to this embodiment of the invention. It is understood that the figures described in the following are schematic and show only a small part of the wafer of the size of a chip which may be diced and separated after the wafer level processing steps.

Etch pits 7 with slightly tapered side walls are introduced from side 3 of the wafer 1. The etch pits 7 are etched with an aspect ratio of at least 3/1, i.e. a ratio of the depth to the width at the surface. The etch pits may be produced by photolithographical structuring as it is common in semiconductor device fabrication. Specifically, a photoresist layer may be applied, exposed using an appropriate mask and developed so that openings in the resist layer at the lateral positions of the etch pits to be introduced are formed.

As a next step shown in Fig. 2, a passivation layer 9 is produced on side 3 of the wafer 1 which also lines the etch pits 7. The passivation layer 9 may be thermally grown silicon oxide.

Then, as shown in Fig. 3, a layer of polycrystalline doped conducting silicon 11 is deposited on side 3 of the wafer. Thereby, the etch pits 7 are filled with the polycrystalline doped silicon 11 so that blind conducting channels are generated extending from side 3 into the bulk of wafer 1.

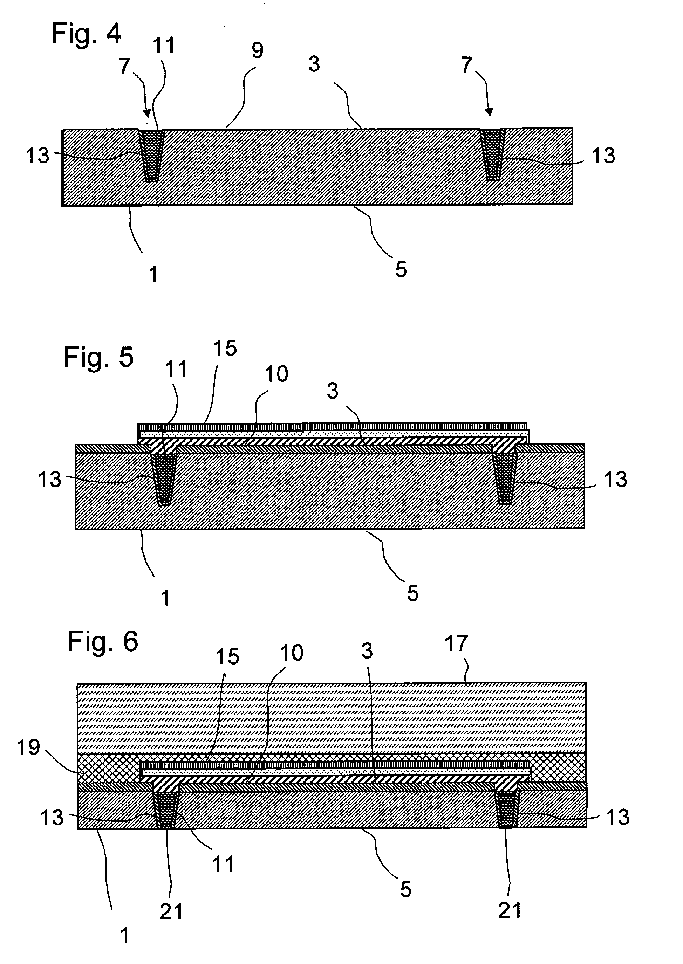

As shown in Fig. 4, the wafer 1 is then planarized to obtain a flat surface an to remove the conducting polycrystalline silicon on the planar areas of side 3 so that conducting silicon 11 only remains in the etch pitches.

The wafer 1 may now be further processed for fabrication of semiconductor circuitry like any usual blank wafer. Subsequently, further process steps for device fabrication using a wafer as shown in Fig. 4 are described with respect to Figs. 5 to 7. Specifically, as shown in Fig. 5, silicon-on-insulator CMOS-devices 15 are fabricated by deposition of layers on side 3 of wafer 1. An insulating layer 10 may be deposited first to electrically insulate the devices 15 from the wafer substrate. The devices are fabricated on top of the blind conducting channels 13 and are directly connected to the channels 13. This way, a very compact design with short electrical connections is achieved.

As shown in Fig. 6, the wafer 1 is then bonded to a support substrate 17 using adhesive 19 and thinned from side 5 so that the blind conducting channels 13 are exposed on thinned side 5 and form conducting channels or through contacts 14 with contact areas 21 on side 5. Possible adhesives are acrylic adhesive or epoxy. It is also possible to use anodic bonding to join the wafer 1 and the support substrate 17.

If the devices 15 include optoelectronic components, a glass-wafer may be used as support substrate 17. Particularly, the support substrate may advantageously form a part of the packaging for wafer 1 with devices 15.

However, if other packaging materials are employed or if the side 3 of wafer 1 needs to be acessed, e.g. for electrically contacting the chips diced from the wafer, a non-permanent bond may be used so that the support substrate can be removed after thinning the wafer.

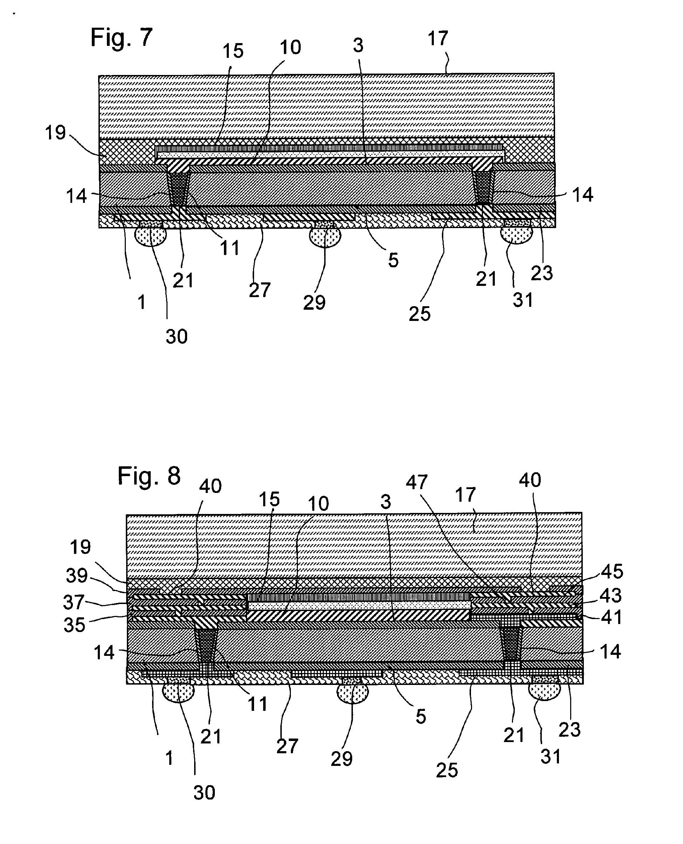

Fig. 7 shows the wafer 1 after final processing steps. A passivation layer 23 has been deposited onto side 5 to insulate the electrical contacts on side 5 against the wafer substrate. Further, a thin film metal interconnect layer 25 is deposited with conductors connecting to the conducting channels 14. For mounting and electrically connecting the devices, a solder mask 27 with openings 29 filled with solder 30 to contact regions of the metal interconnect layer 25 has been applied. Finally, solder bumps 31 are applied onto solder 30.

Finally, after wafer level packaging has been completed, the wafer may be diced to detach separate semiconductor chips.

Fig. 8 shows a variant of the wafer shown in Fig. 7. According to this embodiment, the devices 15 have been produced between the blind conducting channels. Then, one or more interconnecting layers are produced on side 3 of wafer 1, whereby the exemplary embodiment of Fig. 8 comprises three interconnecting layers 41, 43, 45 interconnected by through contacts 47 and separated by passivation layers or insulation layers 35, 37. For example, the devices 15 may be gate arrays of ASIC circuits, whereby the interconnection layers 41, 43, 45 interconnect the gates of the gate arrays appropriately according to the functions to be implemented.

Additionally, the interconnection layers 41, 43, 45 are connected to the conducting channels 14 underneath forming electrical through contacts through the substrate of wafer 1. A final passivation layer 39 may be deposited on top of interconnection layer 45. The passivation layer 39 comprises openings 40 to test pads of the interconnection layers 41, 43, 45. The test pads may be used for testing the circuitry prior to bonding the support substrate 17 to wafer 1.

In the embodiment of Figs. 1 to 7, the blind conducting channels 13 have been produced prior to any fabrication steps for the semiconductor circuitry. However, a processed wafer as shown in Fig. 8 may as well be obtained if the blind conducting channels are introduced into a wafer with prefabricated circuitry or semiconductor elements. Particularly, as in the example of Fig. 8, the wafer may comprise prefabricated gate arrays, whereby the semiconductor circuits are then finalised by the interconnection layers.

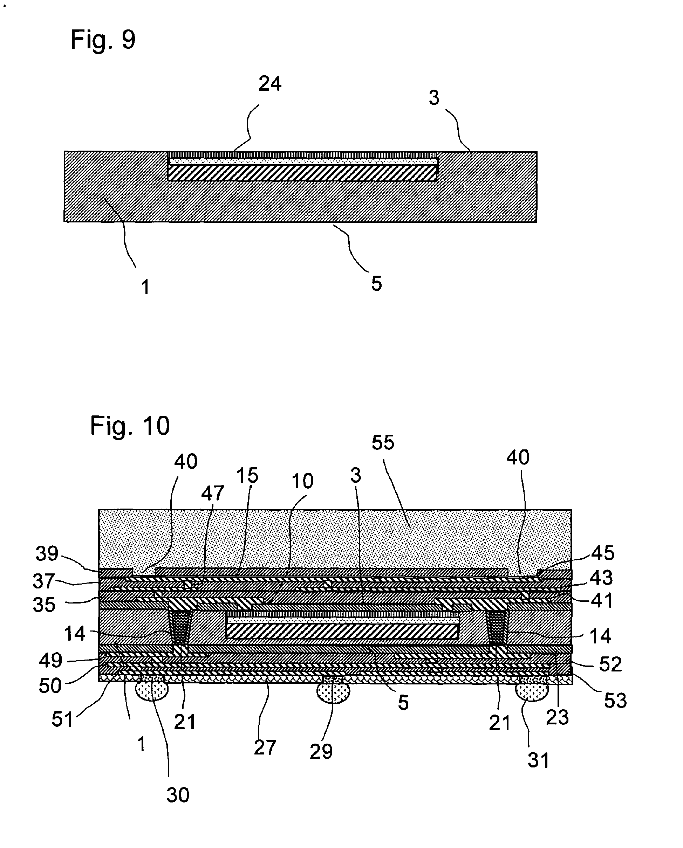

In difference to SOI-semiconductor elements as in the embodiment described with reference to Fig. 8, semiconductor devices may as well be at least partly formed in the substrate of wafer 1. Fig. 9 shows an embodiment of such a wafer 1. The wafer 1 of this embodiment comprises a prefabricated gate array 24 on side 3 which is subsequently processed as described with reference to Figs. 1 to 4 and Fig. 8.

Fig. 10 shows an embodiment wherein multilayer metal interconnections have been formed on both sides 3, 5 of the wafer. Accordingly, this embodiment differs from the wafer shown in Fig. 8 in that a multilayer interconnect structure with interconnect layers 49, 50, 51 separated by insulation layers 52, 53 has been built up on side 5 of the wafer. Like the single interconnect layer 25 of the embodiment shown in Figs. 7 or 8, the metal layers of the multilayer interconnect structure connect to the contact areas 21 of the conducting channels 14. This embodiment is particularly suited for very fine pitch conducting channels 14, e.g. less than 100 µ, and highly integrated circuitry, as a high density interconnect structure with multilayer interconnections on both sides 3, 5 is achieved.

By way of example, instead of a glass support substrate like in the embodiments of Figs. 7 and 8, a plastic molding material 55 forms the front side of wafer 1. This may be achieved, e.g., by bonding a support substrate to the plastic molding material, thinning the wafer 1 on side 5 to expose the conducting channels and later remove the support substrate. As well, if the plastic molding material imparts sufficient mechanical strength, the plastic molding material may itself form a support substrate during the thinning of wafer 1.

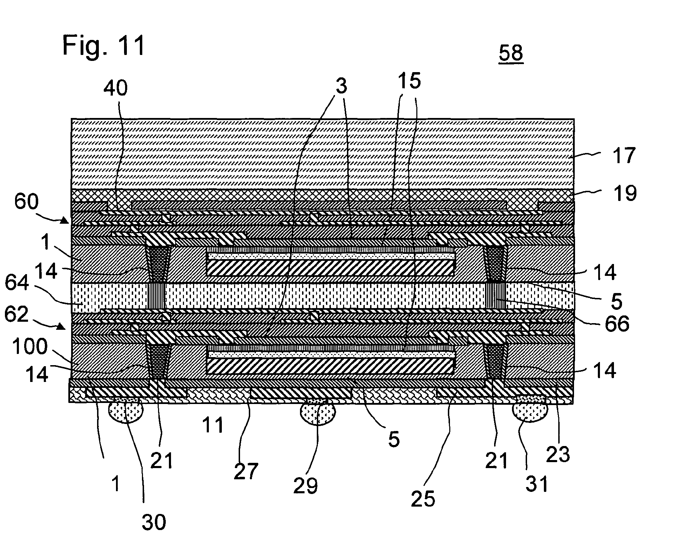

Fig. 11 shows an embodiment of a wafer stack 58 with wafers 1 and 100. Both wafers 1, 100 are processed similarly as explained with reference to Figs. 1 to 6, whereby as well one or both wafers may comprise prefabricated semiconductor elements like the embodiment shown in Fig. 9. Specifically, conducting channels 14 have been introduced into both wafers 1, 100. Further, on sides 3 of both wafers 1, 100, multilayer interconnect structures 60, 62 similarly to the embodiment shown in Fig. 8 or 10 have been produced. As in the embodiment shown in Fig. 8, the multilayer interconnect structures 60, 62 comprise metal layers connecting to the conducting channels and the devices 15, whereby the metal layers are separated by intermediate insulating layers. A photosensitive passivation layer 64 with electrically conducting interconnect vias 64 is fabricated on one of the wafers 1, 100 before bonding the wafers 1, 100 together.

The interconnect vias 34 electrically connect between conductors of the multilayer interconnect structure 62 on wafer 100 and the conducting channels 14 through wafer 1. Accordingly, as multilayer interconnect structure 62 electrically connects to device 15 on wafer 100 and the conducting channels 14 through wafer 1 electrically connect to device 15 of wafer 1 via interconnect structure 60, both devices 15 on the wafers are electrically interconnected. The second side 5 of wafer 100 of the exemplary embodiment shown in Fig. 11 has been processed according to the embodiment shown in Fig. 8.

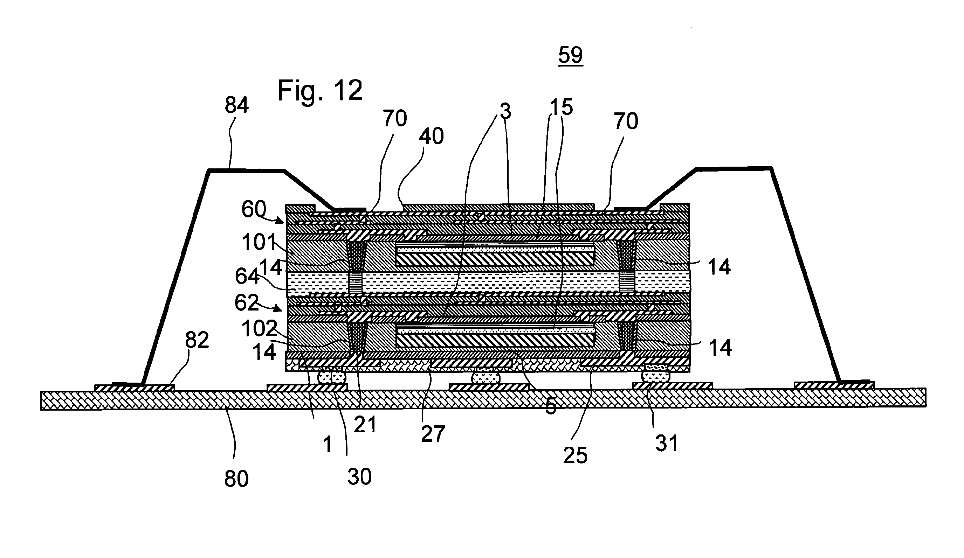

Fig. 12 shows a chip 59 with stacked semiconductor substrates 101, 102 diced from a wafer stack and mounted on a circuit board 80. The wafer stack may be similarly to the stack 58 shown in Fig. 11. Accordingly, if a wafer stack similarly to the embodiment of Fig. 11 is used to fabricate chip 59, the semiconductor substrates 101, 102 are diced from the stacked wafers 1, 100. Wire bond pads 70 are defined on the multilayer interconnect structure 60 on side 3 of semiconductor substrate 101 and are accessible via openings 40 in a final passivation layer over the multilayer interconnect structure 60.

Wire bonds 84 have been produced between wire bond pads 70 and conductors 82 of the circuit board 80. Further electrical connections between the chip 59 and the circuit board 80 have been established by surface mounting the chip 59 onto conductors of the circuit board 80 using the solder bumps 30 on interconnect layer 25 on side 5 of substrate 102. As the chip 59 is electrically contacted on both sides, a very high density interconnect structure may be employed. Of course, a chip with only one substrate, e.g. a chip diced from a wafer shown in Fig. 10, may be mounted this way as well.

As the chip is contacted with wire bonds on side 3 of substrate 101, the respective wafer is bonded non-permanently to a support substrate for thinning and exposing the blind conducting channels. Accordingly, if a wafer stack 58 as shown in Fig. 11 is used to dice the chip 59, the support substrate 17 and adhesive 19 are removed prior to contacting the chip 59 by wire bonds 84.

In all exemplary embodiments described with respect to the figures, semiconductor wafers, particularly silicon wafers have been employed as substrates for the semiconductor devices. However, if thin film semiconductor devices such as SOI-devices are fabricated, other materials, particularly insulating materials may be employed for the wafer substrates as well. For example, glass or ceramics wafers may be used. If the wafer material is insulating, then the step of producing a passivation layer in the etch pits may be ommited.

Although this disclosure describes illustrative embodiments of the invention in detail, it is to be understood that the invention is not limited to the embodiments as described, anc that various modifications may be applied within the scope of the invention. In particular, features of the exemplary embodiments described with respect to the enclosed figures may be combined without leaving the scope of the invention.

## Claims

1. A method for fabricating a wafer substrate for semiconductor circuits, whereby
- etch pits are introduced into a wafer having a first side and an opposite second side, and
- conducting material is deposited into said etch pits, so that blind conducting channels are formed which extend from the first side of said wafer into said wafer substrate, and whereby the blind conducting channels are formed prior to fabricating or finishing semiconductor circuits on said first side of said wafer.

2. The method according to claim 1, further including producing a passivation layer in said etch pits.

3. The method according to the preceding claim, wherein said wafer substrate is a silicon wafer and said passivation layer is produced by thermally growing silicon oxide.

4. The method according to claim 1 or 2, wherein doped silicon is deposited into said etch pits as conducting material.

5. The method according to one of the preceding claims, whereby said blind conducting channels are introduced in a blank wafer.

6. The method according to one of the preceding claims, whereby said wafer substrate comprises prefabricated gate arrays, or whereby gate arrays are fabricated after forming said blind conducting channels, and whereby finishing semiconductor circuits on said wafer substrate comprises forming metal interconnections between gates of said prefabricated gate arrays.

7. The method according to one of the preceding claims, whereby said first side of said wafer substrate is planarized after deposition of conducting material into said etch pits.

8. The method according to one of the preceding claims, wherein etch pits are produced having a ratio of depth to width of at least 3 to 1, preferably of at least 10 to 1.

9. The method according to one of the preceding claims, wherein etch pits are produced having a lateral size of 15 micron or less, preferably of 7 micron or less.

10. The method according to one of the preceding claims, wherein etch pits are produced having a pitch of 150 micrometer or less, preferably 100 micrometer or less.

11. The method of producing a wafer with semiconductor devices, wherein a wafer is produced according to one of the preceding claims, and wherein semiconductor circuits are fabricated or finished on said first side of said wafer substrate, and wherein electrical connections are established from said semiconductor circuits to said blind conducting channels and wherein said wafer substrate is thinned from said second side at least until said blind conducting channels are uncovered at said second side so that contact regions are produced at said second side which establish an electrical connection via conducting channels to said semiconductor circuits.

12. The method according to the preceding claim, wherein said semiconductor circuits are produced over at least a part of said blind conducting channels so that said semiconductor circuits directly connect to said conducting channels.

13. The method according to claims 11 or 12, wherein at least one electrical interconnection layer with electrical connection lines is produced on said first side connecting said semiconductor circuits to said conducting channels and/or establishing electrical connections between gates of gate arrays on said first side of said wafer substrate.

14. The method according to one of claims 11 to 13, wherein MOS- and/or SOI-elements are formed by deposition on said first side of said wafer substrate.

15. The method according to one of claims 11 to 14, wherein at least one interconnection layer is produced on said second side of said wafer, connecting to said conducting channels.

16. The method according to one of claims 11 to 15, wherein a support substrate is bonded to said first side of said wafer, and wherein said wafer is thinned from its second side with the support substrate bonded to said first side.

17. The method according to one of claims 11 to 16, wherein said wafer is bonded to at least one a further wafer produced according to one of claims 11 to 16 so that a wafer stack of semiconductor device wafers is obtained, whereby electrical connections between said devices on said wafer and said further wafer are produced.

18. A wafer substrate for fabricating semiconductor circuits thereon, preferably producable by a method according to the preceding claims, having first and second opposite sides, whereby blind conducting channels extend from said first side into said wafer substrate without extending down to said second side, and whereby said blind conducting channels comprise etch pits which extend into said wafer substrate and are filled with conducting material.

19. The wafer substrate according to the preceding claim, wherein said etch pits are lined with a passivation layer

20. The wafer substrate according to one of the both the preceding claim, whereby said conducting material is doped silicon.

21. The wafer substrate according to one of both preceding claims, comprising prefabricated gate arrays on said first side.

22. The wafer substrate according to any of the preceding claims, wherein said etch pits have a ratio of depth to width of at least 3 to 1, preferably of at least 10 to 1.

23. A wafer with semiconductor devices comprising semiconductor circuits formed on a first side of a wafer substrate according to one of the preceding claims, whereby said semiconductor devices are connected to conducting channels which extend through said wafer substrate and electrically connect said semiconductor devices to said second side, whereby said conducting channels comprise etch pits which are tapered towards said second side of said wafer substrate, said etch pits being lined with a passivation layer and filled with conducting material.

24. The wafer according to the preceding claim, wherein said etch pits are filled with doped silicon.

25. The wafer according to the preceding claim, wherein said conducting channels are positioned underneath said semiconductor circuits.

26. The wafer according to one of the preceding claims, further comprising at least one electrical interconnection layer with electrical connection lines connecting said semiconductor circuits to said conducting channels and/or establishing electrical connections between gates of said gate arrays on said first side of said wafer substrate.

27. The wafer according to the preceding claim, wherein at least some of said conducting channels are positioned underneath said metal interconnection layer.

28. The wafer according to one of the preceding claims, wherein at least some of said conducting channels are positioned underneath said semiconductor circuits and are directly connected to said semiconductor circuits.

29. The wafer according to one of the preceding claims, wherein said semiconductor circuits comprise MOS-elements and/or SOI-elements deposited onto said wafer substrate.

30. The wafer according to one of the preceding claims, wherein said conducting channels have a lateral size of 15 micron or less, preferably of 7 micron or less.

31. The wafer according to one of the preceding claims, comprising conducting channels having a pitch of 150 micrometer or less, preferably 100 micrometer or less.

32. A wafer stack comprising at least two wafers according to one of the preceding claims bonded together with electrical connections between the devices of the wafers.

33. A semiconductor chip having at least one integrated circuit thereon, produced by dicing said chip from a wafer or wafer stack according to one of claims 23 to 32.
